# EUROPEAN PATENT APPLICATION

(11) **EP 0 580 381 A1**
(43) Date of publication of application: **26.01.1994**
(21) Application number: 93305638.4
(22) Date of filing: 19.07.1993
(51) Int. Cl.: H01L 21/48, H05K 1/03, C04B 41/87

(54) **Sealing porous electronic substrates**

(30) Priority: 20.07.1992 US 915215
(71) Applicant: DOW CORNING CORPORATION, Midland Michigan 48686-0994 (US)
(72) Inventor: Chandra, Grish, Midland, Michigan (US); Haluska, Loren Andrew, Midland, Michigan (US)
(74) Representative: Kyle, Diana

(57) **Abstract**

The present invention relates to a novel methods for sealing porous ceramic substrates. The method comprises impregnating the substrate with a silicon-containing material and then converting the material to a ceramic. The resultant substrates are resistant to moisture penetration and can be easily manipulated without damage.

## Description

The present invention relates to a method of sealing porous ceramic electronic substrates with ceramic materials. The resultant substrates are advantageous in the electronics industry because of their reliability and ease in processing.

Ceramic substrates for use in the electronics industry are known in the art. Such substrates can be used, for example, to mount conductor circuits or to dissipate heat from the conductive elements. Ceramics are useful for these purposes since they are relatively lightweight, good thermal conductors and generally poor electrical conductors. Unfortunately, ceramics often crack or chip when machined or handled. They are often porous and, thus, allow for the transport of impurities, such as water and the like, which may damage the conductive elements.

It is known in the art that the porosity of such ceramics can be decreased by infiltration with various resins. For example, Sato et al. in European Patent Publication 0 196,865 and Enomoto in U.S. Patent No. 4,792,646 teach impregnation of porous electronic substrates with resins such as epoxies, polyimides, silicones and the like which may, additionally, be filled with ceramic powders. Such non-ceramic resins, however, do not have the same properties as the materials claimed herein.

It is also known in the art that electronic devices can be protected by covering them with ceramic coatings. For instance, Haluska et al. in U.S. Patent Nos. 4,749,631 and 4,756,977 describe processes for forming ceramic coatings on electronic devices which comprise diluting silica precursors in solvents, applying the solutions to substrates, evaporating the solvents and heating the coated substrates to a temperature between 150 and 1000°C. These patents, however, teach coating a formed electronic device and do not teach sealing a porous electronic substrate.

The inventors herein have unexpectedly found that the process of the present invention provides a simple method for sealing substrates for the electronics industry.

The present invention relates to a method of sealing porous ceramic electronic substrates and comprises impregnating the substrate with a composition comprising a silicon-containing preceramic material. The impregnated substrate is then heated to a temperature sufficient to convert the silicon-containing preceramic material to a ceramic.

The present invention is based on the unexpected finding that porous ceramic electronic substrates filled with silicon-containing ceramics provide desirable properties. The inventors herein postulate that the silicon-containing ceramics plug the pores of the substrates to prevent transport of impurities, such as water and the like (i.e., the substrate becomes less permeable). In addition, the silicon-containing ceramics render the substrates less fragile (i.e., it increases their cohesive strength) so they can be manipulated, machined, diced, etc. as necessary.

The electronic substrates of the present invention are known in the art and some are commercially available. They comprise porous ceramic materials which can be formed into the desired shape for electronic applications such as heat sinks and electronic circuit substrates such as electronic circuit boards. These porous materials include, for example, alumina, silicon carbide, silicon nitride, aluminum nitride, beryllium oxide, silica, diamond-like carbon, silicon, boron nitride, boron carbide and combinations of the above.

Methods for the production of these substrates are likewise known in the art. For example, they can be produced by depositing a coating of preceramic material on a substrate and heating to convert it into the porous ceramic (eg., heatsinks on copper). Similarly, a thin film can be deposited on a substrate by a process such as physical vapor deposition. Alternatively, the preceramic material can be molded into the desired shape and pyrolyzed to form the porous ceramic substrate.

After a substrate is obtained from the above processes, it is then impregnated in accordance with this invention with a silicon-containing ceramic material. This is generally accomplished by impregnating the substrate with a composition comprising a preceramic silicon-containing material. The impregnated ceramic substrate is then heated to a temperature sufficient to convert the preceramic silicon-containing material to a ceramic.

As used herein, the term "silicon-containing preceramic material" describes material, which can be rendered sufficiently flowable to impregnate and coat the ceramic and which can be converted to the solids known to those skilled in the art as ceramics. These materials include, for example, precursors to silicon oxides, silicon nitride, silicon oxynitride, silicon oxycarbide, silicon carbonitride, silicon oxycarbonitride, silicon carbide and the like.

The preferred preceramic compounds to be used in the process of this invention are precursors to silicon oxides, especially silica. The silica precursors which may be used in the invention include, but are not-limited to, hydrogen silsesquioxane resin (H-resin), hydrolyzed or partially hydrolyzed RₙSi(OR)₄₋ₙ or combinations of the above, in which R is an aliphatic, alicyclic or aromatic substituent of 1-20 carbon atoms such as an alkyl (e.g., methyl, ethyl and propyl); alkenyl (e.g., vinyl or allyl); alkynyl (e.g., ethynyl), cyclopentyl, cyclohexyl and phenyl and in which n is 0-3.

The term H-resin is used in this invention to describe a variety of hydridosilane resins (HSiO_{3/2}) which may be either fully condensed or those which may be only partially hydrolyzed and/or condensed. Although not represented by this structure, various units of these resins may have either no, or more than one, Si-H bonds due to various factors involved in their formation and handling. Exemplary of fully condensed H-resins are those formed by the process of Frye et al. in U.S. Patent No. 3,615,272. This polymeric material has units of the formula (HSiO_{3/2})ₙ in which n is generally 8-1000. The resin has a number average molecular weight of from 800-2900 and a weight average molecular weight of between 8000-28,000 (obtained by GPC analysis using polydimethylsiloxane as a calibration standard). When heated sufficiently, this material yields a ceramic coating substantially free of SiH bonds.

Exemplary H-resin which may not be fully condensed (polymers containing units of the formula HSi(OH)ₓO_{(3-x)/2}) include those of Bank et al. in U.S. Patent No. 5,010,159 or those of Weiss et al. in US Patent No. 4,999,397. Bank et al. describe a process which comprises hydrolyzing hydridosilanes in an arylsulfonic acid hydrate hydrolysis medium to form a resin which is then contacted with a neutralizing agent. Recent experimentation by the inventors has shown that an especially preferred H-resin which forms substantially crack-free coatings may be prepared by our method in which the acid/silane ratio is greater than 2.67:1, preferably 6/l. Weiss et al. describe a process which comprises hydrolyzing trichlorosilane in a non-sulfur containing polar organic solvent by the addition of water or HCl and a metal oxide. The metal oxide therein acts as a HCl scavenger and, thereby, serves as a continuous source of water.

An exemplary H-resin which is not fully hydrolyzed or condensed is that having units of the formula HSi(OH)ₓ(OR)_{y}O_{z/2}, in which each R is independently an organic group which, when bonded to silicon through the oxygen atom, forms a hydrolyzable substituent, x = 0-2, y = 0-2, z = 1-3, x + y + z = 3 and the average value of y over all of the units of the polymer is greater than 0. Examples of R groups in the above equation include alkyls of 1-6 carbon atoms such as methyl, ethyl and propyl; aryls such as phenyl; and alkenyls such as vinyl. These resins may be formed by a process which comprises hydrolyzing a hydrocarbonoxy hydridosilane with water in an acidified oxygen-containing polar organic solvent.

A platinum, rhodium or copper catalyst may be admixed with the hydrogen silsesquioxane resin to increase its rate and extent of conversion to silica. Any platinum, rhodium or copper compound or complex that can be solubilized in this solution will be operable. For instance, an organo-platinum composition such as platinum acetylacetonate or rhodium catalyst RhCl₃[S(CH₂CH₂CH₂CH₃)₂]₃, obtained from Dow Corning Corporation, Midland, Mich. are all within the scope of this invention. The above catalysts are generally added to the solution in an amount of between 5 and 500 ppm platinum or rhodium based on the weight of H-resin.

Another type of silica precursor material useful herein includes hydrolyzed or partially hydrolyzed compounds of the formula RₙSi(OR)₄₋ₙ in which R and n are as defined above. Some of these materials are commercially available, for example, under the tradename ACCUGLASS. Specific compounds of this type include methyltriethoxysilane, phenyltriethoxysilane, diethyldiethoxysilane, methyltrimethoxysilane, dimethyldimethoxysilane, phenyltrimethoxysilane, vinyltrimethoxysilane, tetramethoxysilane, tetraethoxysilane, tetrapropoxysilane and tetrabutoxysilane. After hydrolysis or partial hydrolysis of these compounds, the silicon atoms therein may be bonded to C, OH or OR groups, but a substantial portion of the material is believed to be condensed in the form of soluble Si-O-Si resins. Compounds in which x = 2 are generally not used alone as volatile cyclic structures are generated during pyrolysis, but small amounts of said compounds may be cohydrolyzed with other silanes to prepare useful preceramic materials.

In addition to the above SiO₂ precursors, other ceramic oxide precursors may also be advantageously used herein either solely or in combination with the above SiO₂ precursors. The ceramic oxide precursors specifically contemplated herein include compounds of various metals, such as aluminum, titanium, zirconium, tantalum, niobium and/or vanadium, as well as various non-metallic compounds, such as those of boron or phosphorous, which may be dissolved in solution, hydrolyzed and subsequently pyrolyzed at relatively low temperatures and relatively rapid reaction rates to form ceramic oxides.

The above ceramic oxide precursor compounds generally have one or more hydrolyzable groups bonded to the above metal or non-metal, depending on the valence of the metal. The number of hydrolyzable groups to be included in these compounds is not critical as long as the compound is soluble in the solvent. Likewise, selection of the exact hydrolyzable substituent is not critical since the substituents are either hydrolyzed or pyrolyzed out of the system. Typical hydrolyzable groups include, but are not limited to, alkoxy, such as methoxy, propoxy, butoxy and hexoxy; acyloxy, such as acetoxy; and other organic groups bonded to said metal or non-metal through an oxygen such as acetylacetonate or an amino groups. Specific compounds, therefore, include zirconium tetracetylacetonate, titanium dibutoxy diacetylacetonate, aluminum triacetylacetonate and tetraisobutoxy titanium.

When SiO₂ is to be combined with one of the above ceramic oxide precursors, generally it is used in an amount such that the final ceramic contains 70 to 99.9 percent by weight SiO₂.

Examples of suitable silicon carbonitride precursors include hydridopolysilazane (HPZ) resin and methylpolydisilylazane (MPDZ) resin. Processes for the production of these materials are described in U.S. Patent Nos. 4,540,803 and 4,340,619.

The above preceramic material is then used to impregnate the substrate. The material can be used in any practical form but it is preferred to use a solution comprising the preceramic material in a suitable solvent. If this solution approach is used, the preceramic solution is generally formed by simply dissolving or suspending the preceramic material in a solvent or mixture of solvents. Various facilitating measures such as stirring and/or heat may be used to assist in the dissolution. The solvents which may be used in this method include alcohols, such as ethyl or isopropyl; aromatic hydrocarbons, such as benzene or toluene; alkanes, such as n-heptane or dodecane; and ketones, cyclic dimethylpolysiloxanes, esters or glycol ethers, in an amount sufficient to dissolve the above materials to low solids. For instance, enough of the above solvent can be included to form a 0.1-85 weight percent solution.

The porous substrate is then impregnated with the above solution. Means such as immersion, vacuum impregnation, pressure impregnation, supercritical fluid infiltration or simple coating (spin, spray, dip or flow) with sufficient preceramic material will all function in the claimed invention.

The solvent is then allowed to evaporate. Any suitable means of evaporation such as simple air drying by exposure to an ambient environment or the application of a vacuum may be used.

Although the above described methods primarily focus on using a solution approach, one skilled in the art would recognize that other equivalent means of impregnating the porous ceramic substrate, such as a heatsink (eg., melt impregnation) would also function herein and are contemplated to be within the scope of this invention.

The preceramic material is then converted to the silicon-containing ceramic by heating it to a sufficient temperature. Generally, the temperature is in the range of 50 to 800°C. depending on the pyrolysis atmosphere and the preceramic compound. Preferred temperatures are in the range of 50 to 600°C. and more preferably 50-400°C. Heating is generally conducted for a time sufficient to ceramify, generally up to about 6 hours, with less than 2 hours being preferred.

The above heating may be conducted at any effective atmospheric pressure from vacuum to superatmospheric and under any effective oxidizing or non-oxidizing gaseous environment, such as those comprising air, O₂, an inert gas (N₂, etc.), ammonia, amines, moisture-and N₂O etc.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

Additional coatings may be applied over these coatings if desired. These can include SiO₂ coatings, SiO₂/ceramic oxide layers, silicon-containing coatings, silicon-carbon containing coatings, silicon-nitrogen containing coatings, silicon-oxygen-nitrogen containing coatings, silicon-nitrogen-carbon containing coatings and/or diamond-like carbon coatings. Methods for the application of such coatings are known in the art and are described in U.S. Patent No.4,756,977.

The substrates produced by these methods are impermeable to impurities such as water and the like which can be detrimental to electronic circuits. In addition, the substrates herein are less fragile and, thus, can be manipulated, machined, cut, diced, etc. without damage to the substrate.

The following examples are included so that one skilled in the art may more readily understand the invention.

### EXAMPLE 1

A piece of porous silicon carbide (27.99 g) was dried at 100°C. to a constant weight of 27.98 g over a period of 6.5 hours. The silicon carbide was then immersed in a 10 wt % solution of H-resin (made by the method of U.S. Patent No. 5,010,159) in heptane with 60 ppm platinum pentanedionate (based on H-resin). The silicon carbide piece was taken out of the solution and allowed to air dry to a constant weight of 28.45 g. The coated silicon carbide piece was then heated at 175°C. for 3 hours in an atmosphere created by bubbling ammonia through a concentrated solution of ammonium hydroxide. A final weight of 28.46 g was obtained.

The resultant silicon carbide piece was pore-free and had excellent mechanical properties.

### Example 2

A 2.54 cm square piece of porous alumina (0.0127 cm thick) deposited on a 0.0127 cm thick copper substrate (7.5281 g) was dried at 100°C. to a constant weight of 7.5274 g over a period of 6.5 hours. The alumina piece was then immersed for 1 hour in a 10 wt % solution of H-resin (made by the method of U.S. Patent No. 5,010,159) in heptane with 60 ppm platinum pentanedionate (based on H-resin). The alumina piece was taken out of the solution and allowed to air dry to a constant weight of 7.5329 g. The coated alumina piece was then heated at 175°C. for 3 hours in an atmosphere created by bubbling ammonia through a concentrated solution of ammonium hydroxide. A final weight of 7.5338 g was obtained.

The resultant alumina piece was pore-free and had excellent mechanical properties.

### Example 3

A 3.81 cm diameter porous alumina disc (0.476 cm thick) was immersed in a 5 wt % solution of H-resin (made by the method of U.S. Patent No. 5,010,159) and platinum pentanedionate (120 ppm platinum based on H-resin) in heptane for 5 minutes. The alumina disc was taken out of the solution and allowed to air dry for 20 minutes. The alumina disc was then heated at 700°C. for 2 hours in air. This process was repeated 2 additional times with the immersion time being increased to 1.75 hours for each repetition.

The resultant alumina disc was pore-free and had excellent mechanical properties.

### EXAMPLE 4

A rectangular piece of porous silicon carbide (4.52 cm long X 1.07 cm wide X 0.51 cm thick - Wt. = 7.2368 g) was dried at 100°C. for 47 hours to a constant weight of 7.2358 g. The silicon carbide was then immersed in a 10 wt % solution of hydridopolysilazane polymer (made by the method of U.S. Patent No. 4,540,803) in a xylene/heptane solvent for 4 hours. The silicon carbide piece was taken out of the solution and allowed to air dry for 4 hours to a constant weight of 7.2519 g. The silicon carbide piece was then heated at 800°C. for 1 hour in air to yield a piece that weighed 7.2412 g.

The resultant silicon carbide piece was pore-free and had excellent mechanical properties.

## Claims

1. A method of sealing a porous ceramic electronic substrate comprising:
impregnating the porous ceramic electronic substrate with a composition comprising a silicon-containing preceramic material; and
heating the impregnated substrate to a temperature sufficient to convert the silicon-containing preceramic material to a ceramic.

2. The method of claim 1 wherein the silicon-containing preceramic material is diluted in a solvent.

3. The method of claim 1 wherein the porous electronic substrate is made from materials selected from alumina, aluminum nitride, beryllium oxide, silicon nitride, boron nitride, boron carbide, silica, diamond-like carbon, silicon and silicon carbide.

4. The method of claim 1 wherein the silicon-containing preceramic material is selected from silicon, oxygen, nitrogen, carbon and hydrogen.

5. The method of claim 4 wherein the silicon-containing preceramic material is selected from silica precursors, silicon nitride precursors and silicon carbonitride precursors.

6. The method of claim 5 wherein the silica precursor is selected from hydrogen silsesquioxane resin and hydrolyzed or partially hydrolyzed RₙSi(OR)₍₄₋ₙ₎, wherein R is an aliphatic, alicyclic or aromatic substituent of 1-20 carbon atoms and n is 0-3.

7. The method of claim 1 wherein the impregnated substrate is heated at a temperature in the range of 50 to 800°C. for up to about 6 hours.

8. The method of claim 1 wherein the impregnated substrate is heated in an atmosphere selected from air, O₂, inert gases, ammonia, amines, moisture and N₂O.

9. The method of claim 1 wherein the composition comprising a silicon-containing preceramic material also contains one or more modifying ceramic oxide precursors comprising a compound containing an element selected from the group consisting of titanium, zirconium, aluminum, tantalum, vanadium, niobium, boron and phosphorous and wherein the compound contains at least one hydrolyzable substituent selected from alkoxy or acyloxy and the compound is present in an amount such that the ceramic coating contains 0.1 to 30 percent by weight modifying ceramic oxide.

10. The method of claim 1 wherein the composition comprising the silicon-containing preceramic material also contains a platinum, rhodium or copper catalyst in an amount of 5 to 500 ppm platinum, rhodium or copper based on the weight of the silicon-containing preceramic material.
